(19) **Europäisches Patentamt**
**European Patent Office**
**Office européen des brevets**

(11) **EP 4 729 956 A1**

(12) **EUROPEAN PATENT APPLICATION**

(43) Date of publication:
**22.04.2026 Bulletin 2026/17**

(51) International Patent Classification (IPC):
*G01R 31/08* (2020.01)

(21) Application number: **24206973.0**

(52) Cooperative Patent Classification (CPC):
**G01R 31/086; G01R 31/085; G01R 31/088**

(22) Date of filing: **16.10.2024**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Hitachi Energy Ltd**
**8050 Zürich (CH)**

(72) Inventors:
• **NAIDU, Obbalareddi Demudu**
  **560087 Bangalore (IN)**
• **VENKATESAN, Aarthi**
  **600099 Chennai (IN)**

(74) Representative: **Vossius & Partner**
**Patentanwälte Rechtsanwälte mbB**
**Siebertstrasse 3**
**81675 München (DE)**

(54) **METHOD, DEVICE, AND STORAGE MEDIUM FOR FAULT LOCATION ON COLLECTOR GRID NETWORKS**

(57) The disclosure provides a method for determining a fault location in a faulted section in a collector grid feeder, the method comprising obtaining a first voltage and a first current signal at a local end of the section, obtaining a second current signal at a remote node of the section; and determining a fault location based on the first voltage signal, the first current signal, and the second current signal.

Fig. 1B

**Description**

The present disclosure relates to a method for determining a faulted section for a collector grid network, in particular for determining a faulted section of a feeder of the collector grid network. The present disclosure further relates to a method for fault location in a faulted section of the collector grid network, in particular in a faulted section of a feeder of the collector grid network. The disclosure also relates to a corresponding computer-readable storage medium, apparatus, and power grid.

Offshore wind power is becoming a major part of the renewable energy projects portfolio and plays an important role in achieving renewable targets in most of the countries around the world. The global pipeline for offshore wind development capacity is estimated to be more than 270 GW. The need to ensure secure and affordable energy supplies while meeting climate targets has propelled wind power development into a new phase of ever faster growth. The IEA's latest roadmap requires offshore wind annual installations to grow ninefold, from 8.8 GW in 2022 to 80 GW by 2030, with 70 GW to be deployed every year between 2031 and 2050. IRENA foresees nearly 500 GW of cumulative offshore wind installed capacity by 2030 in its latest 1.5C-compliant scenario, and nearly 2,500 GW by 2050.

Consequently, there is a need for a reliable protection scheme for networks such as offshore windfarm networks. However, known methods of the prior art are disadvantageous for several reasons. For example, a faulted segment identification method using wireless sensors [1] is proposed. According to this method, during a fault, an entire segment with fault is disconnected without selectivity. Additionally, this method does not provide the fault location. A further method to detect a directionality based on a fault passage indicator is proposed [2]. Based on a directionality that can be computed using a positive sequence current at each wind generator, a further method [3] to determine a faulted zone, i.e., whether a fault is in a wind turbine or in a cable, is proposed. A further method [4] for identifying a fault within a windfarm using a direction of a phase angle between voltage and current signals at a collector bus is proposed. This method discriminates between internal faults in the protected collector cable feeder sections zones based on differential current magnitudes at each cable feeder section. However, this method is unsuitable for fault location in the windfarm. A machine learning based method [5] for identifying a faulted section using current measurements at each section is further proposed. This method requires offline training to classify the faulted section, and its practical implementation is difficult.

Therefore, there is a need for a method to identify a faulted section of a feeder and accurately pinpoint the location of a fault in collector networks.

Generally, in complex networks such as collector grid networks, developing a reliable protection method is challenging due to the interconnection of different cross sections of cables in a single feeder. In such cases, a faulted section identification approach with communication is a more reliable option. Many devices and sensors such as fault passage indicators are available to monitor the current through each section of the cable. These sensors can be utilized in order to develop a more robust and reliable protection scheme. In this invention, a communication-based method for determining a faulted section and fault location is disclosed which can utilize information from the above-mentioned devices and sensors to locate the fault.

Some or all of the drawbacks of the prior art are addressed by the disclosure as defined by the independent claims. Preferred embodiments are defined by the sub-features of the dependent claims.

The present disclosure relates to a method for determining a faulted section in a collector grid feeder comprising a plurality of sections. The method comprises a) obtaining a voltage at a collector bus at a local end of the feeder, b) obtaining a first current signal through the feeder and a second current signal through the feeder, c) determining a first fault direction value, based on the first current signal and a derivative of the first current signal, and determining a first fault direction based on the first fault direction value, and determining a second fault direction value based on the second current signal and a derivative of the second current signal, and determining a second fault direction based on the second fault direction value, and d) determining a faulted section based on a comparison between the first fault direction and the second fault direction.

This provides a method that is simple to implement in collector grid networks. It is agnostic to the control structure, source impedance and other parameters of power sources such as IBRs employed throughout the collector grid which are typically of proprietary nature and not readily accessible.

It is to be noted that, in the context of the present disclosure, obtaining a value or signal can mean measuring the value or signal using a suitable sensor or device, calculating the value or signal based on available data, and/or receiving the value or signal via any suitable information transmission means.

Various embodiments may preferably implement the following features.

Preferably, in b) the first current signal is obtained for a first section, and the second current signal is obtained for a second section succeeding the first section in a remote direction of the feeder.

This provides a simplified method as it requires only a single current signal per feeder section.

Preferably, in d) the first section is determined as the faulted section when it is determined that the first fault direction and the second fault direction are in opposing directions

This provides a simplified method for determining a faulted section based on the fault direction between two successive feeder sections.

Preferably if in d) the first fault direction and the second fault direction are determined to be in the same direction, steps a) to d) are repeated, wherein in repeated steps a) to d), the second section becomes the first section, and a third section succeeding the second section in a remote direction of the feeder becomes the second section.

This provides an iterative approach to determine a faulted section of a feeder among a plurality of adjacent sections of the feeder.

Further preferably, repeated steps a) to d) are repeated until either the first fault direction and the second fault direction are determined to be in opposing directions, whereby the first section in repeated step d) is determined as the faulted section, or the second section is the remote section of the feeder, whereby the remote section is determined as the faulted section.

This provides an iterative approach to determine a faulted section of a feeder among all sections of the feeder.

Preferably, in a) the first section is the local section of the feeder of the collector grid.

Preferably, in b) respective current signals are obtained at respective local ends of respective sections.

Preferably, in b) the first current signal is obtained at a local end of a first section, and the second current signal is obtained at a remote end of the first section.

Further preferably, the first section is determined as the faulted section if the first fault direction and the second fault direction are in the same direction.

Further preferably, if in d) the first fault direction and the second fault direction are determined to be in opposite directions, steps a) to d) are repeated for a second section different from the first section.

This provides an iterative approach to determine a faulted section of a feeder among a plurality of sections of the feeder.

Further preferably, the first section is the local section of the feeder, and the second section is adjacent to and succeeds the first section in a remote direction of the feeder.

This provides an iterative approach to determine a faulted section of a feeder among all sections of the feeder.

Preferably, the method further comprises e) determining a fault location within the determined faulted section.

The present disclosure also relates to a method for determining a fault location in a faulted section in a collector grid feeder, the method comprising obtaining a first voltage and a first current signal at a local end of the section, obtaining a second current signal at a remote node of the section, and determining a fault location based on based the first voltage signal, the first current signal, and the second current signal.

As with the method for determining a faulted section, the method for determining a fault location provides a method that is simple to implement in collector grid networks for, e.g., windfarms or distributed solar farms. It is agnostic to the control structure, source impedance and other parameters of power sources of inverter-based resources employed throughout the collector grid which are typically of proprietary nature and not readily accessible.

Various embodiments may preferably implement the following features.

Preferably, the first voltage signal is obtained based on zero-sequence impedance parameters of the faulted section.

Utilizing zero-sequence impedance parameters allows the method to ignore infeed into the collector grid from power sources such as IBRs, e.g., such as wind turbines or solar panels, as they do not generate zero-sequence infeed, thus simplifying the method.

Preferably, the first current signal and the second current signal are obtained based on an obtained current through the faulted section.

This further simplifies the method as it is sufficient to obtain a single current signal instead of two current signals.

Further preferably, the current through the faulted section is measured at an infeed/local end of the faulted section.

This further simplifies the method as it obviates the need for further sensors and for further communication of sensor data.

Preferably, the first voltage signal is obtained based on a voltage signal at a collector bus at a local end of the collector grid feeder, and a current through remaining sections of the collector grid feeder arranged in a remote direction from the faulted section.

This simplifies the method as it obviates the need for a dedicated device or sensor at the local end of the faulted section.

Preferably, determining a fault location comprises obtaining a fault current based on the first voltage signal, the first current signal, and the second current signal.

The present disclosure also relates to a method that combines the aforementioned method for determining a faulted section with the aforementioned method for fault location in a faulted section. The method comprises, in a first step, performing the method for determining a faulted feeder section, and subsequently performing the method for fault location on the faulted section determined by the previously performed method for determining a faulted feeder section.

Combining the two methods allows accurate fault location on a feeder of a collector grid network without requiring any knowledge of the control structure, source impedance and other parameters of power sources or inverter-based resources employed throughout the collector grid which are typically of proprietary nature and not readily accessible. Additionally, the two methods combine synergistically in that the inputs required for determining a faulted section are suitable and sufficient for subsequent fault location in that faulted section. Subsequent fault location therefore does not require additional inputs, rendering the combination of the two methods particularly advantageous over existing methods of the prior art.

The present disclosure also relates to a computer program product comprising instructions that, when executed by one or more processors of a management system of a power network, cause the one or more processors to perform a method or a combination of methods as described above.

The present disclosure also relates to a non-transitory computer-readable storage medium comprising the computer program product as described above.

The present disclosure also relates to an apparatus of a power network, the apparatus comprising one or more processors and a non-transitory computer-readable medium as described above.

## Brief description of the drawings

Fig. 1A shows a schematic illustration of a collector grid network according to embodiments of the present disclosure.

Fig. 1B shows a schematic illustration of an exemplary feeder of the collector grid network of Fig. 1A.

Fig. 2 shows a flow chart illustrating methods for determining a faulted section according to embodiments of the present disclosure.

Fig. 3A shows an exemplary portion of power transmission system for determining a fault direction.

Figs. 3B to 3D respective show a flowchart for data pre-processing, a flowchart of a method for determining fault direction, and a flowchart of an alternative method for determining a fault direction according to embodiments of the present disclosure.

Fig. 4A shows a schematic illustration of a portion of an exemplary feeder of the collector grid network of Fig. 1A according to embodiments of the present disclosure.

Fig. 4B shows schematic plots for determining a fault direction of the embodiment of Fig. 4A.

Fig. 4C shows a flow chart illustrating methods for determining a faulted section for embodiments of Figs. 4A and 4B.

Fig. 5A shows a schematic illustration of a portion of an exemplary feeder of the collector grid network of Fig. 1A, according to embodiments of the present disclosure.

Fig. 5B shows schematic plots for determining a fault direction of the embodiment of Figs. 5A.

Fig. 6A shows a schematic illustration of sections of feeder according to embodiments of the present disclosure.

Fig. 6B shows a flow chart illustrating a method for fault location according to embodiments of the present disclosure.

Fig. 7A shows three-phase voltage and current signals obtained at a medium-voltage bus of a collector grid network according to an exemplary embodiment of the present disclosure.

Fig. 7B shows three-phase current signals obtained for different sections of the feeder of the exemplary embodiment.

Fig. 7C shows determined fault directions for the different sections of the feeder of the exemplary embodiment.

Fig. 7D shows a plot of roots as solutions to a linear quadratic equation based on the magnitude of a fault current dependent on the fractional fault location for the exemplary embodiment.

Fig. 8A shows three-phase voltage and current signals obtained at a medium-voltage bus of a collector grid network according to a further exemplary embodiment of the present disclosure.

Fig. 8B shows three-phase current signals obtained for different sections of the feeder of the further exemplary embodiment.

Fig. 8C shows determined fault directions for the different sections of the feeder of the further exemplary embodiment.

Fig. 8D shows a plot of roots as solutions to a linear quadratic equation based on the magnitude of a fault current dependent on the fractional fault location for the further exemplary embodiment.

## Detailed description

Embodiments of the present disclosure will now be described by way of example only and with reference to the following accompanying drawings. In the figures, the same reference numerals denote the same or similar elements.

In the following description, although numerous features may be designated as optional, it is nevertheless acknowledged that all features comprised in the independent claims are not to be read as optional.

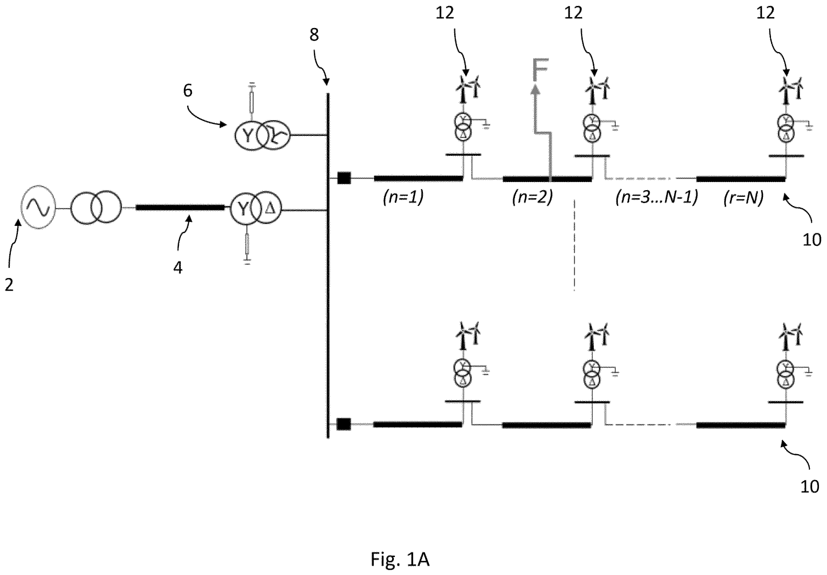

**Fig. 1A** illustrates a collector grid network according to embodiments of the present disclosure. The network is configured to collect power generated by a plurality of power sources 12 such as inverter-based resources, IBRs. Each power source 12 is connected to a feeder 10, wherein a plurality of power sources 12 can be connected to a single feeder 10. A plurality of feeders 10 are connected to a collector bus 8 in parallel. Power sources 12 connected to a respective feeder 10 are connected in series via the respective feeder 10. The collector grid network, and the collector bus 8, in particular, may be provided with safety means 6 to guard against harmful external influences, in particular against lightning strikes by safely channeling lightning energy into a grounding system. For this purpose, the safety means can comprise an equipment air terminal, EAT, and a neutral ground resistor, NGR. The collector bus 8 collects power from the plurality of feeders 10 and directs the collected power to different parts of the collector grid network. For this, transmission means 4 may be provided for transmitting the collected power to a connection point of a power grid 2 to be fed into the power grid 2.

The collector grid network may generally be implemented for any suitable power source(s). In preferred embodiments, the collector grid network is implemented for renewable energy systems such as windfarms or distributed solar farms, wherein the power sources 12 such as IBRs may respectively be wind turbines or solar panels. Since power supplied by wind turbines or solar panels is typically of low voltage such as, e.g., a voltage below 1 kV, the voltage may be stepped up to a medium voltage before being supplied to a respective feeder 10 and collected by the collector bus 8. The collector bus 8 can consequently be operated at medium voltages, typically between 1kV and 35 kV to ensure efficient transmission with minimized power loss over short transmission distances and is therefore typically referred to as a medium voltage, MV, bus 8. Power collected at the MV bus 8 is typically further stepped up at a substation to high voltages for transmission via transmission means 4. For wind or solar farms, in particular offshore farms, the substation can be onshore or offshore, and the transmission means 4 can comprise an export cable for transmitting the collected power to a power grid connection point to be fed into a power grid 2. The export cable is typically operated at high voltages between 110 kV and 220 kV.

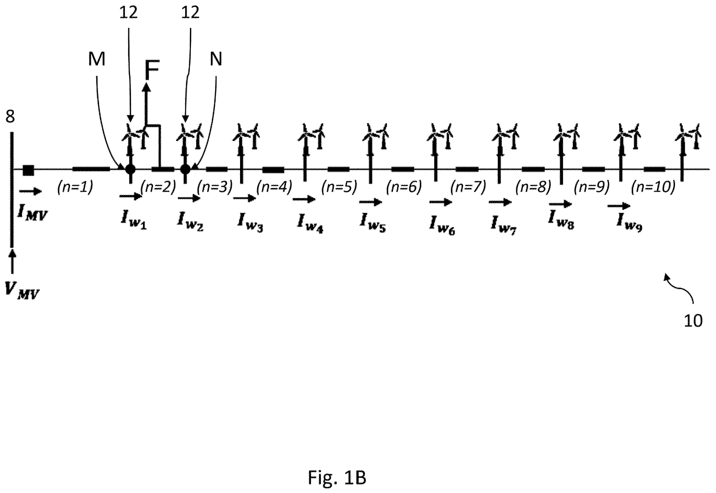

As can be seen in **Fig. 1B,** as illustrated in Fig. 1A, in the illustrated embodiment of the collector grid network of Fig. 1A, the feeder 10 is exemplified by ten individual sections numbered n=1 to 10., wherein r is an index denoting different sections of the feeder 10. The first section *n=1* of the feeder 10 may span between the MV bus 8 and node M at a first wind turbine, while subsequent sections n=2 to 10 each span between subsequent neighboring nodes at power sources 12 from which the feeder 10 collects power. The number of sections is chosen merely for illustrative purposes and can take any suitable number. Notably, a section is not restricted to portions between neighboring power sources 12 but can span between any suitable nodes of the feeder 10, wherein nodes M, N are located at power sources 12 merely for illustrative purpose and can be located at any suitable position on the feeder 10.

In the illustrated embodiment, a fault F in the feeder 10 is detected. For illustrative purpose, this fault is assumed to be present in section 2 of the feeder 10.

It is to be noted that the terms "remote" or "local" for the feeder 10 and related components indicate a relative direction or position of an element, wherein "local" refers to a direction towards or a position that is closer to the MV bus 8, wherein a local terminal end of the feeder 10 is connected to the MV bus 8, and wherein "remote" refers to a direction away from or a position that is further away from the MV bus 8.

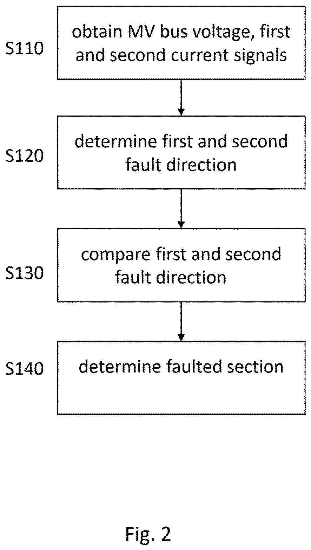

**Fig. 2** illustrates a method for determining a faulted section of a feeder 10 of a collector grid network, wherein the feeder 10 may, in particular, be a feeder 10 as described within the context of embodiments of Figs. 1A and 1B.

In step S110, a voltage signal at the MV bus 8, as well as a first current signal and a second current signal are obtained.

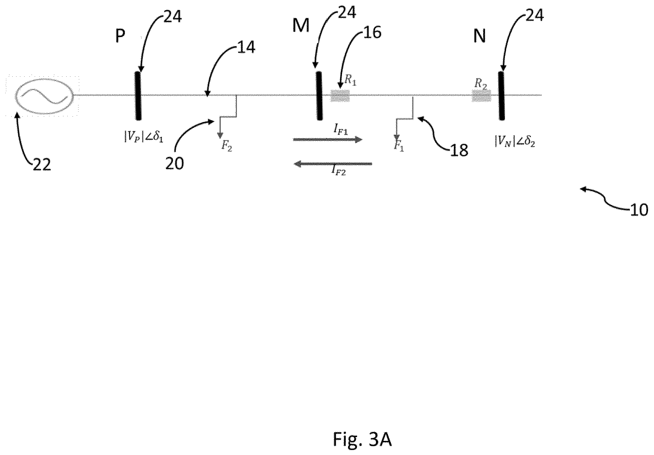

In step S120, a first fault direction for the first current signal is determined, and a second fault direction for the second current signal is determined. A method for determining a fault direction is disclosed in European patent application EP 23 210 743.3 filed on November 17, 2023, and is further described below within the context of Figs. 3A to 3D.

In step S130, the first fault direction and the second fault directions are compared to determine whether the first fault direction and the second fault direction are in the same direction or in opposing directions.

In a fourth step S140, a faulted section is determined if the comparison between the first fault direction and the second fault direction satisfies certain requirements.

It is to be noted that the term fault direction denotes the direction in which a fault is located relative to node, at which a respective current signal is obtained.

The fault direction refers to a direction on the feeder 10 relative to the node, in which (direction) the fault is. If the fault direction is in a first direction, it may be in a first direction relative to the device. If the fault direction is in a second direction, it may be in a second direction (different from the first direction) relative to the device.

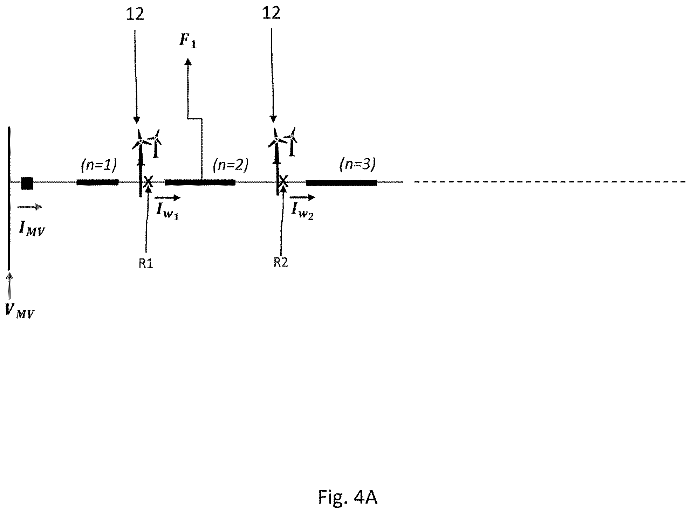

In embodiments, the first current signal and the second current signal are obtained at subsequent and adjacent sections, i.e., for example, at sections 1 and 2 as illustrated in Figs. 1A and 1B, the preceding section 1 is determined as the faulted section if the first fault direction of section 1 and the second fault direction of section 2 are in opposing directions. These embodiments will be described in more detail below in the context of Figs. 4A to 4C.

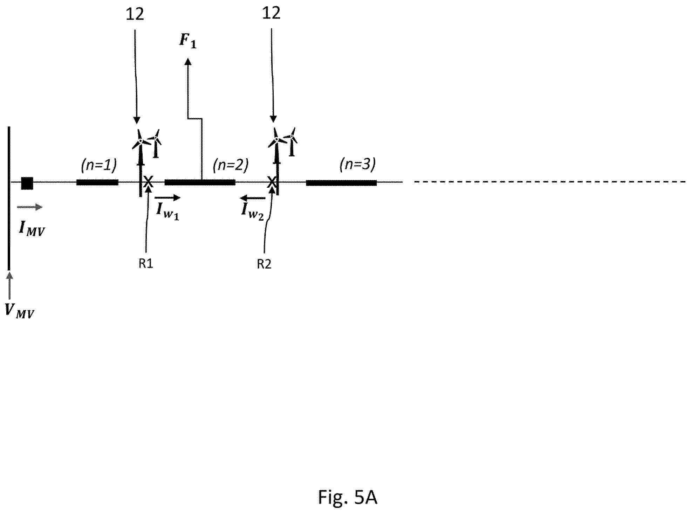

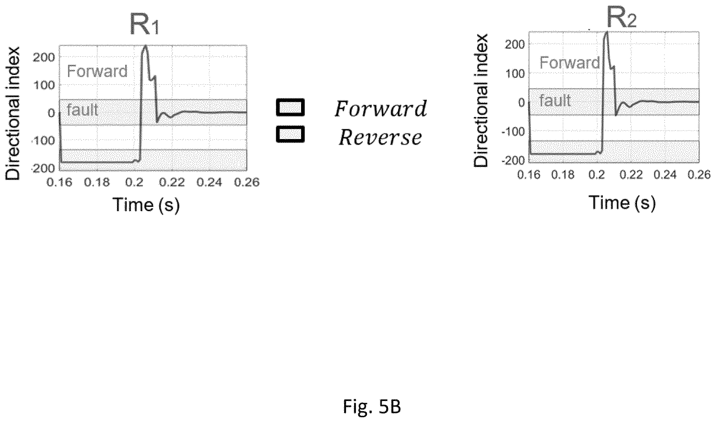

In other embodiments, the first current signal is obtained at a local end of a section and the second current signal is obtained at remote end of the section, the section is determined to be the faulted section if the first fault direction and the second fault direction are in the same direction. These embodiments will be described in more detail below in the context of Figs. 5A and 5B.

In case a section is not determined to be the faulted section, steps S110 to S130 can be repeated for other sections of the feeder 10.

For determining a fault direction, the method as disclosed in EP 23 210 743.3 for determining a fault direction will now be described below in the context of Figs. 3A to 3D.

As shown in Fig. 3A, an exemplary relay 16 (R1) is positioned between a forward fault 18 in a forward direction and a reverse fault 20 in a reverse direction. The relay 16 is connected within the transmission line 14 in such a way that there is a first part of the power transmission line coupled to the relay 16 on one side (for example the side with the forward fault 18) and a second part of the power transmission line coupled to the relay 16 on another side (for example the side with the reverse fault 20. The relay 16 is configured to measure a current signal. It may be configured to additionally measure a voltage signal.

The device mentioned in this disclosure may be the relay 16. Other examples for the device may be a substation, a terminal, or a node, such as nodes M, N, or P, as shown in Figs. 1B and 3A. Notably, a section may span between individual nodes. For example, section 1 of the feeder may span between nodes P and M, and section 2 of the feeder may span between nodes M and N.

The transmission grid 22 is connected to the power transmission line 14. The transmission grid 22 can be a combination of other power system equipment or sub-systems, or a combination of network lines. For example, the equivalent source can represent grouping of one or more of a transmission line, power generator, transformer, reactor, and/or load, or other such combinations. In the context of a collector grid network, the transmission line 14 may correspond to a feeder 10 or a portion of a feeder 10, and the transmission grid 22 may correspond to or comprise a collector bus 8 as illustrated in Figs. 1A and 1B.

Basis for the method for determining a fault direction is given below.

Considering the forward fault 18 $F_1$ and the reverse fault 20 $F_2$ for analysis. The obtained (input) current signal (in a case of three phases: a b and c) seen by the relay 16 $R_1$ can be represented as:

$$i_a(t) = i_{maxa}(t) \cos(wt + \emptyset_A)$$

$$i_b(t) = i_{maxb}(t) \cos(wt + \emptyset_A - 120) \qquad (1)$$

$$i_c(t) = i_{maxc}(t) \cos(wt + \emptyset_A - 240)$$

In step 204, positive and negative differentiation of the current signal for each phase (current phase signal) is computed.

The positive differentiation of the current signal for each phase can be defined as:

$$+i'_{abc}(k) = \frac{1}{2w\Delta T}\big(i_{abc}(k+1) - i_{abc}(k-1)\big) \qquad (2)$$

Similarly, the negative differentiation of the current signal for each phase can be defined as:

$$+i'_{abc}(k) = \frac{1}{2w\Delta T}\left(i_{abc}(k-1) - i_{abc}(k+1)\right) \qquad (3)$$

Where $w = 2\pi f$, k is the sample number, $\Delta T = \frac{1}{Nxf}$, f is the system frequency and N is the number of samples per cycle.

The (positive sequence component of) (input) current (phase) signal(s) ($I_a$, $I_b$, $I_c$), positive differentiated current (phase) signal(s) ($+I'_a, +I'_b, +I'_c$) and negative differentiated current (phase) signal(s) (($-I'_a, -I'_b, -I'_c$) are computed and are denoted as $I_{F1}, +I'_{F1}$ and $-I'_{F1}$ respectively.

Similarly positive sequence component of input voltage signal ($V_a$, $V_b$, $V_c$), may be computed and may be denoted as $V_{F1}$.

Considering impedance between the left bus 24 P to the forward fault 18 $F_1$ is $Z_{PF1}$ and between the right bus 24 N to the reverse fault 20 $F_2$ is $Z_{NF2}$ which are defined as below

$$Z_{PF1} = Z_{PF1}\angle\theta_1 \; ; Z_{NF2} = Z_{NF2}\angle\theta_2 \qquad (4)$$

The method is derived for forward and reverse faults as follows in two cases (case 1: forward fault and case 2: reverse fault):

Case 1: Forward fault:

In this case, the fault 18 $F_1$ is analyzed. The fault 18 $F_1$ is forward fault for the relay 16 $R_1$. From Fig.3A, (post fault) current signal is calculated as in equation (5)

$$I_{F1} = \frac{|V_P|\angle\delta}{Z_{PF1}|\angle\theta_1} = |I_{F_1}|(\delta_1 - \theta_1) \qquad (5)$$

Positive and negative derivative of $I_{F1}$ is given as in (6) and (7) respectively

$$+I'_{F_1} = |I_{F'_1}|\angle\left(\delta_1 - \theta_1 + \frac{\pi}{2}\right) \qquad (6)$$

$$-I'_{F_1} = |I_{F'_1}|\angle\left(\delta_1 - \theta_1 + \frac{3\pi}{2}\right) = |I_{F'_1}|\angle\left(\delta_1 - \theta_1 - \frac{\pi}{2}\right) \quad (7)$$

The angle part (of the phasor) of the value shall be presented between -180° (-π) and 180° (+π).

The reference current is calculated using (6) and (7) as in (8) (wherein the amplitude of the current signal ($|I_{F1}|$) may be ignored for the method, as show later):

$$I_{Ref} = |I_{F1}|\left(\frac{(\angle+I'_{F1} + \angle-I'_{F1})}{2}\right) = |I_{F_1}|\angle(\delta_1 - \theta_1) \qquad (8)$$

The fault directional index (D) is obtained by define a new phasor using (5) and (8)

$$D = |I_{F1}|\angle\left(\angle I_{Ref} - \angle I_{F1}\right) \qquad (9)$$

$$\boldsymbol{D_{Forward}} = |\boldsymbol{I_{F1}}|\angle(+\boldsymbol{0}) \qquad (10)$$

Case 2: Reverse fault:

In this case the fault 20 $F_2$ is analysed. $F_2$ is Reverse fault for the relay 16 $R_1$.

From Fig. 3A, post fault current is calculated as in (11)

$$I_{F2} = \frac{|V_N| \angle \delta_2}{Z_{NF2} | \angle \theta_2} = |I_{F2}|(\delta_2 - \theta_2 + \pi) \qquad (11)$$

Positive and negative derivative of $I_{F2}$ is given as in (12) and (13) respectively

$$+I'_{F_2} = |I'_{F_2}| \angle \left( \delta_2 - \theta_2 + \frac{3\pi}{2} \right) = |I'_{F_2}| \angle \left( \delta_2 - \theta_2 - \frac{\pi}{2} \right) \qquad (12)$$

$$-I'_{F_2} = |I'_{F_2}| \angle \left( \delta_2 - \theta_2 + \frac{\pi}{2} \right) \qquad (13)$$

The reference current is calculated using (12) and (13) as in (14) (again, the amplitude of the current signal ($|I_{F2}|$) may be ignored for the method)

$$I_{Ref} = |I_{F2}| \left( \frac{(\angle +I'_{F2} + \angle -I'_{F2})}{2} \right) = |I_{F2}| \angle (\delta_2 - \theta_2) \qquad (14)$$

The fault directional index is obtained by define a new phasor using (14) and (11)

$$D = |I_{F2}| \angle (\angle I_{Ref} - \angle I_{F2}) \qquad (15)$$

$$\boldsymbol{D_{Reverse}} = |\boldsymbol{I_{F2}}| \angle (-\boldsymbol{\pi}) \qquad (16)$$

From these two cases, it can be seen that the fault direction index (or fault direction value) has a value of 0° (in an ideal case) if the fault is in forward direction. The fault direction value has a value of -180° (-π) if the fault is in reverse direction.

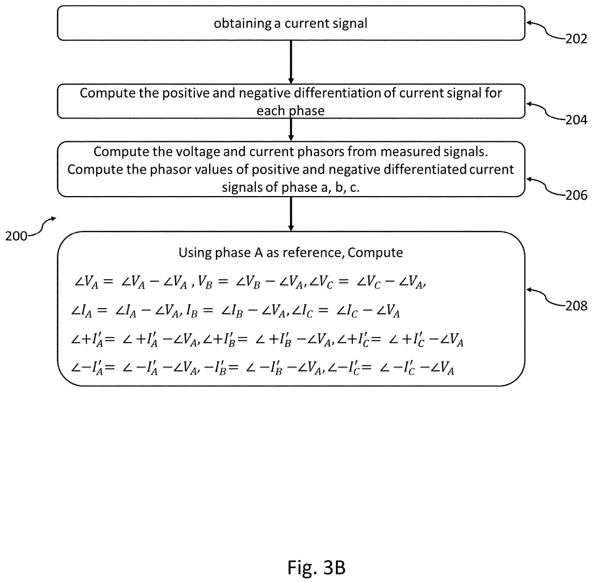

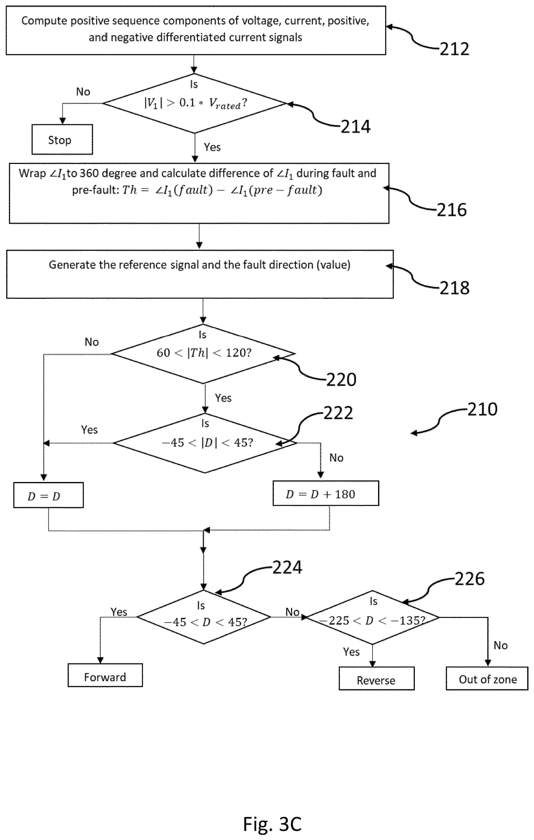

Fig. 3B shows a flowchart for data a pre-processing method 200 and Fig. 3C shows a flowchart of a method 210 of the disclosure. These methods for determining a fault direction will be described with reference to the portion of feeder 10 of Fig. 3A.

In step 202, a current signal is obtained. The current signal may be measured by the relay 16. The current signal may represent the current on the power transmission line 14. Additionally, a voltage signal may be obtained (measured). Step 202 may be alternatively, may comprise, or may be comprised by measuring instantaneous voltage and current signals. The current (phase) signal(s) may be as in equation (1) above.

In step 204, positive and negative differentiation of the current signal for each phase (current phase signal) are computed. This may be as equations (2) (for positive differentiation) and (3) (for negative differentiation) above.

In step 206, the voltage and current phasors from the measured signals are computed. Further, the phasor values of positive and negative differentiated current signals of phase a, b, c may be computed.

In step 208, the current phase signals and derivatives of the current phase signals are preprocessed by: subtracting an angle of a first voltage phase signal of the two or more voltage phase signals from and current phase signals and subtracting the angle of the first voltage phase signal from all derivatives of the current phase signals. This may be calculated as follows:

$$\angle I_A = \angle I_A - \angle V_A, I_B = \angle I_B - \angle V_A, \angle I_C = \angle I_C - \angle V_A$$

$$\angle +I'_A = \angle +I'_A - \angle V_A, \angle +I'_B = \angle +I'_B - \angle V_A, \angle +I'_C = \angle +I'_C - \angle V_A$$

$$\angle -I'_A = \angle -I'_A - \angle V_A, -I'_B = \angle -I'_B - \angle V_A, \angle -I'_C = \angle -I'_C - \angle V_A$$

It is also possible to additionally subtract the angle of the first voltage phase signal from all voltage phase signals, as follows:

$$\angle V_A = \angle V_A - \angle V_A, V_B = \angle V_B - \angle V_A, \angle V_C = \angle V_C - \angle V_A,$$

Fig. 3C shows a flowchart of a method 210 of the disclosure. Here, $I_1$ denotes the current signal, $V_1$ denotes positive sequence fault voltage and D denotes the computed directionality index (= fault direction value). The method may require instantaneous current samples to generate the reference signal and positive sequence voltage angle as input to compute the direction of the fault for the relay (fault direction value).

In step 212, positive sequence components of voltage, current, positive, and negative differentiated current signals are computed. This may comprise the method 200 of Fig. 3B.

In step 214, it is determined whether a magnitude of a positive sequence voltage is bigger than a threshold. This may filter for signals which are week and are poor for calculating. This step is optional. The comparison, whether the magnitude of the positive sequence voltage is bigger than the threshold, may be as follows:

$$\text{If } |V_1| > k1 * V_{rated}, \Rightarrow \text{continue}$$

$$\text{If } |V_1| < k1 * V_{rated}, \Rightarrow \text{stop}$$

Scalar factor k1 is settable to adjust the threshold as needed. In embodiments, k1 is set as 0.1

In step 216, $\angle I_1$ is wrapped to 360° (degree or $2\pi$) and a difference of $\angle I_1$ is calculated between fault and pre-fault: *Th= $\angle I_1$ (fault)- $\angle I_1$ (pre-fault).*

Wrapping $\angle I_1$ to 360 degree may be done by adjusting $\angle I_1$ to the same angle in the range of - 180° ($-\pi$) to +180° ($+\pi$) (for example 370° would be wrapped to 10°).

In step 218, a reference signal and (subsequently) a fault direction value is generated. The reference signal (or reference current) $I_{Ref}$ may be calculated by an average of angles of the derivative of the current signal, the derivative of the current signal comprising a positive derivative of the current signal and a negative derivative of the current signal:

$$I_{Ref} = \left( \frac{(\angle + I_1' + \angle - I_1')}{2} \right)$$

Where $\angle$ represents "angle of". Alternatively, the reference signal may be calculated by further multiplying a magnitude of the current signal (or of one current phase signal $I_1$) to it, as shown here:

$$I_{Ref} = |I_1| \left( \frac{(\angle + I_1' + \angle - I_1')}{2} \right)$$

The fault direction value D may be calculated by:

$$D = \left( \angle I_{Ref} - \angle I_1 \right)$$

Alternatively, the fault direction value D may be calculated by:

$$D = |I_1| \angle \left( \angle I_{Ref} - \angle I_1 \right)$$

Summarizing the calculation of the fault directional index D with the calculation of the $I_{ref}$, the fault directional index D may be calculated by

$$D = |I_F| \left[ \angle \left( \left( \frac{\angle + I'_F + \angle - I'_F}{2} \right) \right) - \angle I_F \right],$$

or

$$D = \left[ \angle \left( \left( \frac{\angle + I'_F + \angle - I'_F}{2} \right) \right) - \angle I_F \right],$$

where $\angle$ is the "angle of", $I_F$ is the current signal, and $I'_F$ is the time derivative of the current signal.

In step 220, the absolute value of Th is compared to thresholds. If $60 < |Th| < 120$ then continue to step 222. Else, continue to step 224.

In step 222, the angle (integer value) of the fault direction value D is compared to thresholds. If $-45 > zD > 45$, 180 is added to D (numbers may be degrees (angle)). Else, D remains the same. In either case, it is continued to step 224.

In steps 224 and 226, the (angle of the) fault direction value is compared to thresholds. If $-45 < \angle D < 45$, the fault is a forward fault. If $-225 < \angle D < -135$ (numbers may be in degrees (angle)), the fault is a reverse fault. Else, a problem message may be displayed to a user.

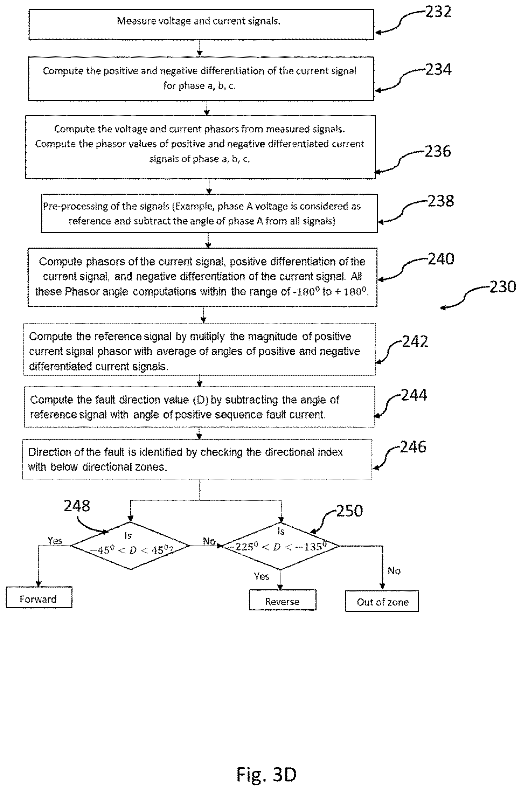

Fig. 3D shows an alternative method 230. In step 232, voltage and current signals may be measured. This step may be similar to (comprise, be exchanged with) step 202. In step 234, the positive and negative differentiation of fault current signal for phase a, b, c are computed. This step may be similar to step 204. In step 236, the voltage and current phasors from measured signals may be computed. The phasor values of positive and negative differentiated current phase signals (a, b, c) may also be computed. In step 238, the signals may be preprocessed (Example, phase A voltage is considered as reference and subtract the angle of phase A from all signals). This step may be similar to step 208. Steps 232 to 238 may be similar to steps 202 to 208.

In step 240, phasor of current signal, positive differentiation of the current signal, and negative differentiation of the current signal may be computed. All these Phasor angle computations may be wrapped within the range of -180° to + 180°. Steps 238 and 240 may be in a swapped order.

In step 242, the reference signal may be computed by multiplying the magnitude of positive sequence fault current phasor with average of angles of positive and negative differentiated fault currents. This step may be similar to the part of step 218 in which the reference signal is computed.

In step 244, the fault direction value (D) may be computed by subtracting the angle of reference signal with angle of positive sequence fault current. This step may be similar to the part of step 218 in which the fault direction value is computed.

In step 246, a direction of the fault may be identified by checking the fault direction index with directional zones. This may be done as shown in steps 248 and 250. Steps 248 and 250 may be similar to steps 224 and 226.

As described for embodiments described in the context of Fig. 2, the logic for determining a faulted section based on determined fault directions depends on the position, at which current signals are obtained. In embodiments, current signals are obtained at nodes at respective local ends of the sections n=1...N of the feeder 10.

For a section, as shown for example in **Fig. 4A,** a fault F1 is assumed to be in section n=2. Here, a first current signal is obtained at node R1 that is arranged at the local end of the section n=2, and a second current signal is obtained at node R2 that is arranged at the local end of the section n=3. Current signals may be obtained via relays or other suitable devices. Here, at node R1, the current signal of current $I_{w1}$ into section 2 from the local end of section 2 is obtained, while at node R2, the current signal of a current $I_{w2}$ into section 3 from the local end of section 3 is obtained.

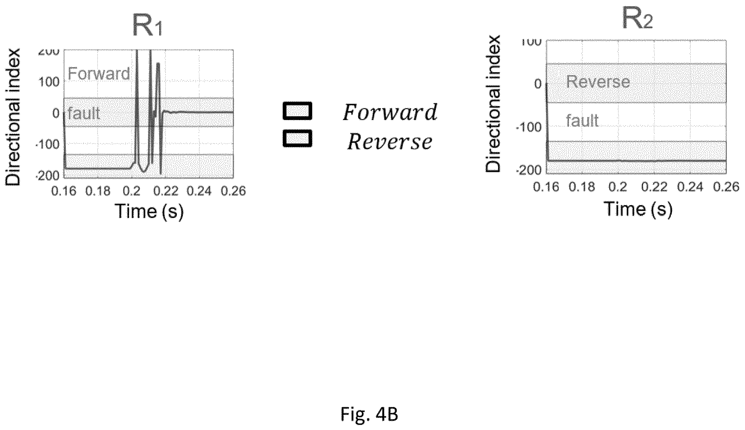

**Fig. 4B** shows respective plots for the fault direction determined at node R1 and node R2. Since at node R1, the current signal of current $I_{w1}$ into section 2 from the local end of section 2 is obtained, and since the fault F1 is located within section 2, the fault direction at node R1 is determined as "FORWARD". Since at node R2, the current signal of a current $I_{w2}$ into succeeding section 3 from the local end of section 3 is obtained, and since the fault F1 is located within section 2 preceding section 3, the fault direction at node R2 is determined as "REVERSE".

Therefore, for embodiments where current signals are obtained at nodes at respective local ends of the sections of the feeder 10, a faulted section can generally be determined by determining whether the fault directions in two adjacent sections of the feeder 10 are opposite to each other ("FORWARD" and "REVERSE", or "REVERSE" and "FORWARD").

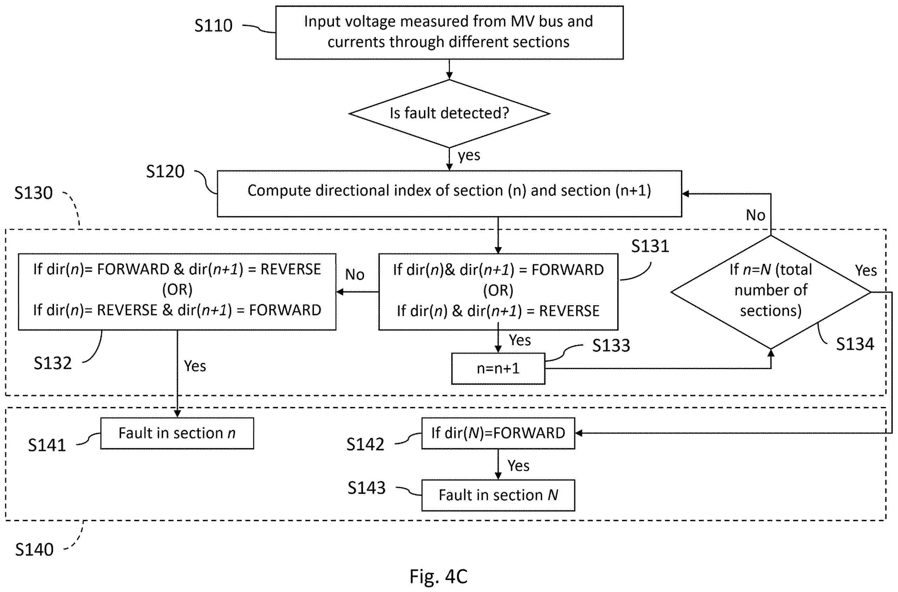

**Fig. 4C** illustrates a flow chart describing in more detail steps S110 to S140 for determining a faulted section, as already described in the context of embodiments of Fig. 2, for embodiments in which current signals are obtained at nodes at respective local ends of the section, as described above in the context of Figs. 4A and 4B. Notably, steps S110 and S120 can be performed as described in the context of embodiments of Fig. 2. The first current signal $I_{Wr}$ is obtained at a first section (n) of the feeder, where r is an index denoting a section of the feeder, and the second current signal $I_{Wr+1}$ is obtained at a subsequent section (n+1) of the feeder, i.e., at a section subsequent to section (n).

Once a directional index for a preceding section (n) and a subsequent section (n+1) are determined, in step 130, the fault directions dir(n) and dir(n+1) can be determined and compared. In step 131, it is compared whether the fault directions dir(n) and dir(n+1) are both in a same direction, i.e., in a "FORWARD" direction or a "REVERSE" direction. If the fault directions are determined to not be in the same direction, the method proceeds to step 132 where it is compared whether the fault directions dir(n) and dir(n+1) are both in opposing directions, i.e., whether the first fault direction dir(n) is in a "FORWARD" direction and the second fault direction dir(n+1) is in a "REVERSE" direction, or vice versa. If the fault directions are determined to be in opposing directions, the section (n) at which the first current signal is obtained is determined to be the faulted section.

If in step S131 the fault directions dir(n) and dir(n+1) are determined to be in a same direction, the method proceeds to step S133 where the index n is increased to *n+1,* and steps S120 and S130 are repeated with the increased index n+1, i.e., the process is repeated for a subsequent section.

It should be noted that respective current signals $I_{W_r}$ can be obtained during each repetition of steps S110 to 130. Alternatively, all current signals $I_{W_r}$ for all sections *n=1...N* can be obtained in an initial step S110, wherein N denotes the number of sections of the feeder.

The repetition cycle stops either when the process proceeds to steps S132 and S141, or when in step S134 the index n reaches N, i.e., the total number of sections of the feeder 10. In case the index n reaches N, it is determined in step S142 whether the fault direction is in a "FORWARD" direction. If the fault direction is determined to be in a "FORWARD" direction, in step S143 the remote section N of the feeder 10 is determined to be the faulted section.

In other embodiments, it is also possible that current signals are obtained at nodes at respective local end and remote ends of the sections n=1...N of the feeder 10.

For a section, as shown for example in **Fig. 5A,** a fault F1 is assumed to be in section n=2. Here, a first current signal is obtained at node R1 that is arranged at the local end of the section n=2, and a second current signal is obtained at node R2 that is arranged at the remote end of the section n=3. Current signals may be obtained via relays or other suitable devices. Here, at node R1, the current signal of current $I_{W_1}$ into section 2 from the local end of section 2 is obtained, while at node R2, the current signal of a current $I_{W_2}$ into section 2 from the remote end of section 2 is obtained.

**Fig. 5B** shows respective plots for the fault direction determined at node R1 and node R2. Since at node R1, the current signal of current $I_{W_1}$ into section 2 from the local end of section 2 is obtained, and since the fault F1 is located within section 2, the fault direction at node R1 is determined as "FORWARD". Since at node R2, the current signal of a current $I_{W_2}$ into section 2 from the remote end of section 2, i.e., the end opposite the local end, is obtained, and since the fault F1 is located within section 2 preceding section 3, the fault direction at node R2 is also determined as "FORWARD".

Therefore, for embodiments where current signals are obtained at nodes at respective local end and remote ends of the sections n=1...N of the feeder 10, a faulted section can generally be determined by determining whether the fault direction determined at the local and the remote end of a section are the same ("FORWARD" and "FORWARD", or "REVERSE" and "REVERSE").

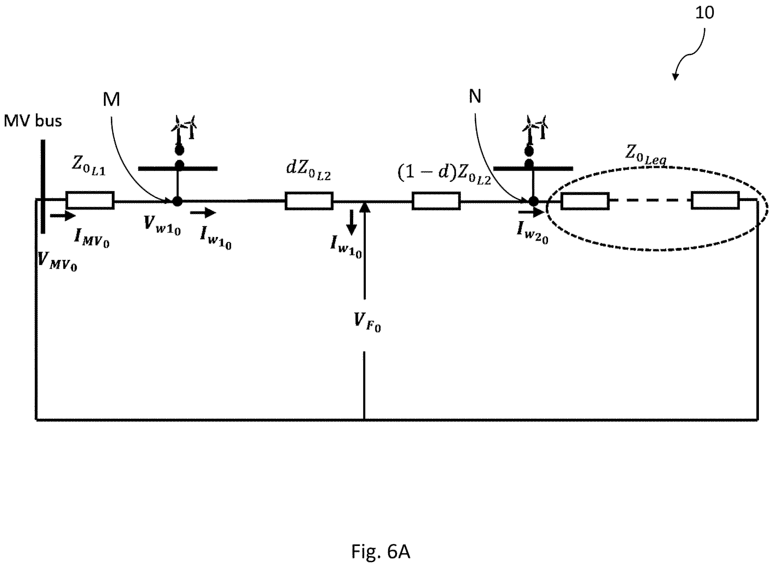

**Fig. 6A** illustrates a zero-sequence diagram of a portion of a faulted feeder, wherein the feeder is preferably a feeder 10 as described above in the context of embodiments of Figs. 1A to 5B.

Considering the fault in feeder 10., the zero-sequence diagram of the faulted feeder 10 is as shown in Fig. 6A. There, $Z_{0_{L_n}}$ is the zero-sequence impedance of the $n^{th}$ section for the system shown in Figs. 1A and 1B. For instance, $Z_{0_{L_1}}$ is the zero-sequence impedance of section n=1 as shown in Figs. 1A and 1B. As the fault is in section n=2 in Fig. 6A, the zero-sequence impedance of section n=2 can be divided in to $dZ_{0_{L_2}}$ and $(1-d)dZ_{0_{L_2}}$, where d is the fault location. The zero-sequence impedance of the rest of the feeders can be denoted as $dZ_{0_{L_{eq}}}$ which can be expressed as in (17).

$$Z_{0_{L_{eq}}} = \sum_{n=j+1}^{N} Z_{0_{L_n}} \qquad (17)$$

where, j is the index of the faulted section and N is the total number of sections.

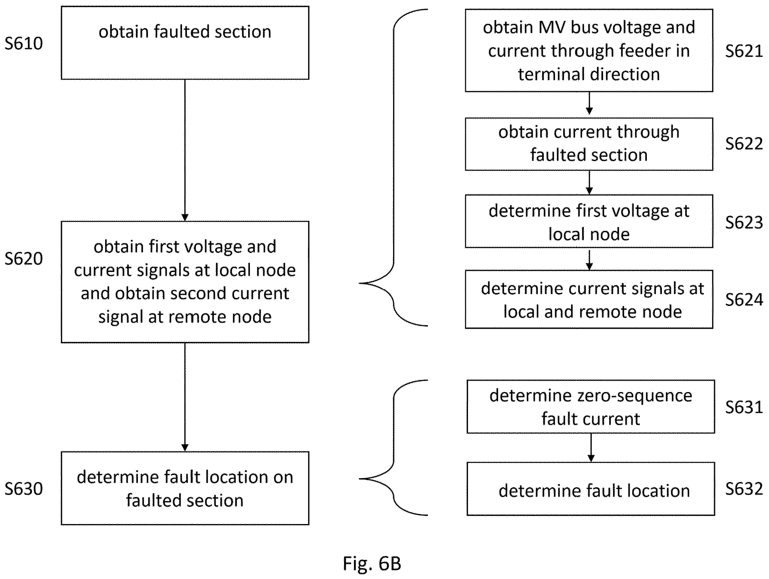

**Fig. 6B** illustrates a method for fault location on a faulted section of a feeder 10 of a collector grid network. An embodiment of such a feeder is exemplified in Fig. 6A.

In a step S610, information on the determined faulted section is obtained. The faulted section may generally be determined using any suitable method. However, in preferred embodiments, the faulted section is determined using a method as described above in the context of embodiments of Figs. 1A to 5B. This is particularly advantageous, as the inputs obtained for determining the faulted section according to the methods described above are suitable and sufficient for fault location in the determined faulted section, as will be further detailed below.

In step S620, a first voltage signal and a first current signal are obtained at a local end of the faulted section. Additionally, a second current signal at a remote end of the faulted section is obtained. While the first voltage signal, the first current signal, and the second current signal may generally be measured using one or more suitable sensors or devices, it is preferred to obtain these signals as described below in optional steps S621 to S624.

In step S621, the MV bus 8 voltage can be obtained as previously described in step S110 in the context of embodiments of Figs. 2 and 4C for the purpose of determining a fault direction. Additionally, the current through the feeder 10 or sections of the feeder 10 in a remote direction of the feeder 10 relative to faulted section are obtained. Additionally, in a step S622, the current through the faulted section can be obtained as described in step S110 in the context of embodiments of Figs. 2 and 4C for the purpose of determining a fault direction. In step S623, the first voltage signal at the local end can be determined based on the MV bus 8 voltage and the current through sections of the feeder. In step S624, the first current signal at the local end of the faulted section and the second current signal at the remote end of the faulted section can be determined based on the current through the faulted section.

In step S630, the fault location within the faulted section is determined. Here, it is preferred that optional steps S631 and S632 are performed. In step S631, a zero-sequence fault current is determined. In Step S632, the fault location is determined based on a magnitude of the zero-sequence fault current.

In the following, methods for fault location described above in the context of embodiments of Fig. 6B are applied and described in an exemplary manner on a faulted feeder 10 described in the context of embodiments of Fig. 6A.

In the circuit shown in Fig. 6A, the voltage of each section (excluding the MV bus 8) can be determined for each section as in (18)

$$V_{w_{n0}} = V_{w(n-1)0} - I_{w(n-1)0}Z_{0_{Ln}} \tag{18}$$

The zero-sequence fault point voltage ($V_{F_0}$) can be expressed in terms of each section voltage and currents as in (19)

$$V_{F_{n0}} = V_{W_{n0}} - I_{w_{n0}}(d * Z_{0_{Ln}}) \tag{19}$$

The fault point voltage can also be expressed in terms of $Z_{0_{Leq}}$ as in (20).

$$V_{F_{n0}} = I_{F_{n0}} \left( Z_{0_{Leq}} + (1-d)Z_{0_{Ln}} \right) \tag{20}$$

Where, $I_{F_{no}} = 3(I_{w_{n0}} - I_{w(n+1)_0})$ , as fault current is three times the zero-sequence current in ground faults. The above fault current expression operates under the assumption that there is no zero-sequence infeed from the windfarm side.

Equating (19) and (20) and simplifying yields

$$I_{F_{n0}} = \frac{V_{w_{n0}} - I_{w_{n_0}}(dZ_{0_{Ln}})}{\left( Z_{0_{Leq}} + (1-d)Z_{0_{Ln}} \right)} \tag{21}$$

Considering the possibility of asynchronization in the measurements for obtaining current signals, fault location is based on the magnitude of the fault current. Equating the magnitude of the left-hand side and the right-hand side of (21) yields the quadratic equation in (22)

$$Ad^2 + Bd + C = 0 \tag{22}$$

$$A = \left| I_{F_{n0}} \right|^2 * (g^2 + h^2) - (c^2 + d^2)$$

$$B = -2 * \left( \left| I_{F_{no}} \right|^2 * (eg + fh) - 2(ac + bd) \right)$$

$$C = \left| I_{F_{n0}} \right|^2 * \left( (e^2 + f^2) - (a^2 + b^2) \right)$$

where *a, b, c, d, e, f, g*, and *h* are defined as,

$$V_{W_{n0}} = a + jb;$$

$$-I_{W_{n0}}(Z_{0_{Ln}}) = c + jd;$$

$$3\left(Z_{0_{L_{eq}}} + Z_{0\text{Ln}}\right) = e + jf;$$

$$3Z_{0\text{Ln}} = g + jh;$$

As known, a quadratic equation as in (22) provides two root values d1 and d2 for the fault location d. Since the fault location d is a fractional location, i.e., a value denoting the fraction of the length of the faulted section, from the local end of faulted section, at which the fault is located, the value for the fault location d must satisfy $0<d<1$. The final fault location d therefore can be determined as follows:

If ($d1>=0$ and $d1<1$) then $d = d1$, else $d= d2$

The absolute fault location ($d_{abs}$) can then be determined as follows:

Absolute fault location($d_{abs}$) = length until faulted section (FS) + d*length of faulted section (fs).

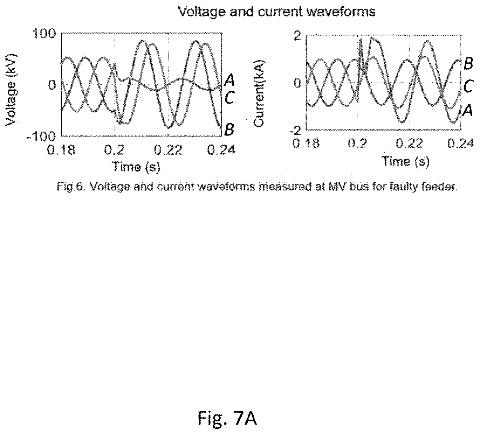

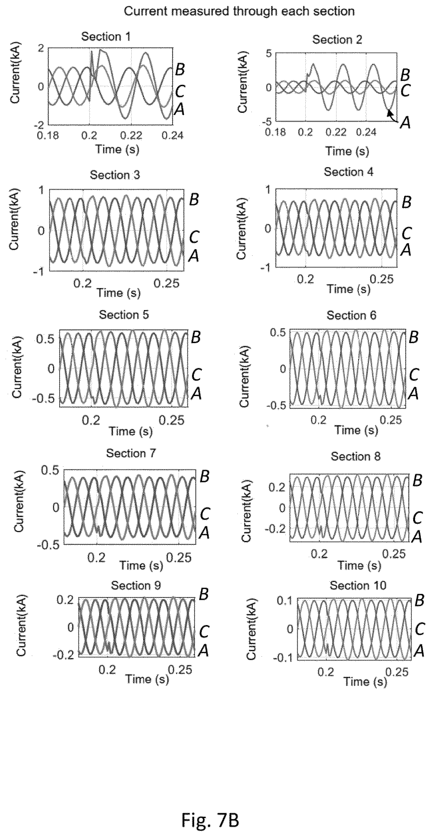

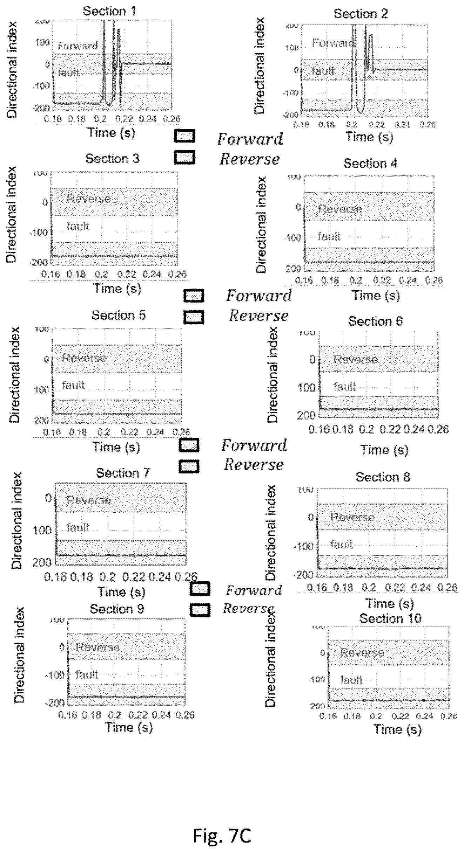

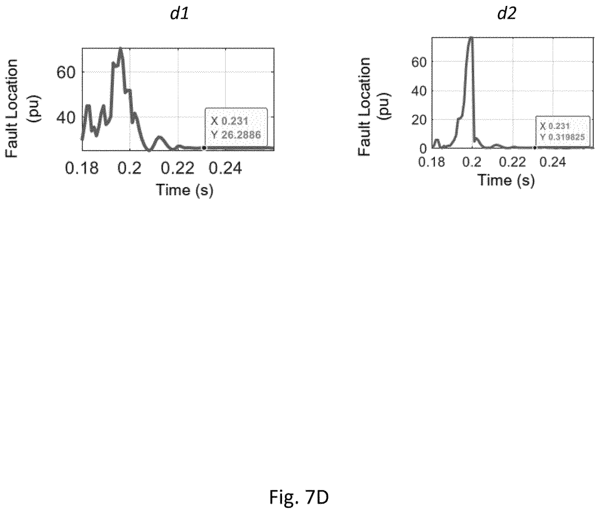

In the following, an illustrative example for aiding understanding of the present invention is described.
Consider an A-g fault at 4 km from the MV bus in the feeder 10 as illustrated in Figs.1A and 1B. The fault resistance is 5Ω.
First, a three-phase voltage signal at the MV bus and three-phase current signals of currents through each section 1 to 10 are obtained. The voltage signal at the MV bus 8 of the faulted feeder 10 is shown in Fig. 7A, and current signals for current through each section 1 to 10 are shown in Fig. 7B, where the signal for each phase is respectively denoted with the letter "A", "B", or "C".
Subsequently, the fault direction for current signals for currents through sections 1 to 10 are determined. The determined fault directions for sections 1 to 10 are shown in Fig. 7C. As can be seen the fault direction of section 2 is "FORWARD", while the direction of section 3 is "REVERSE". Consequently, based on the method steps as described for embodiments in the context of Figs. 2 and 4C, in particular steps S132 and S141, section 2 is determined to the faulted section.
Based on the obtained inputs and the determined faulted section, the method for fault location as described in the context of embodiments of Figs. 6A and 6B is performed. The resulting square roots of equation (22) are shown in Fig. 7D. As can be seen, square root d1 is larger than 1 and square root d2 is smaller than 1. Therefore, d2 is selected as the fault location d. The results are summarized in table 1 below.

| Table 1 | | | | | | |
|---------|---------|---------------|------------------------------------|------------------|-----------|-----------|
| Root $d1$ | Root $d2$ | Root selected | $d_{abs}$ (km) = FS (km) + $d$ *fs (km) | Actual FL (km) | Error (m) | Error (%) |
| 26.288 | 0.3198 | 0.3198 | 3+(0.319*3) = 3.959 | 4 | 40.6 | 0.135 |

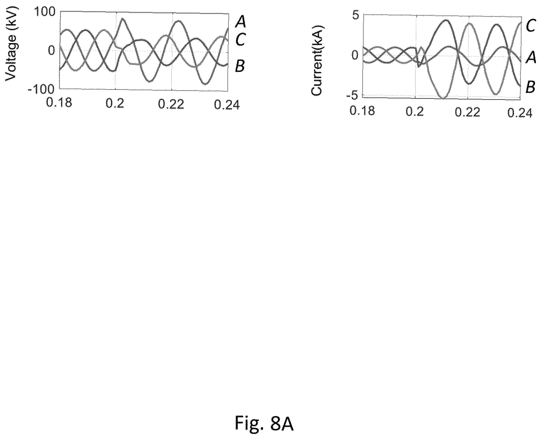

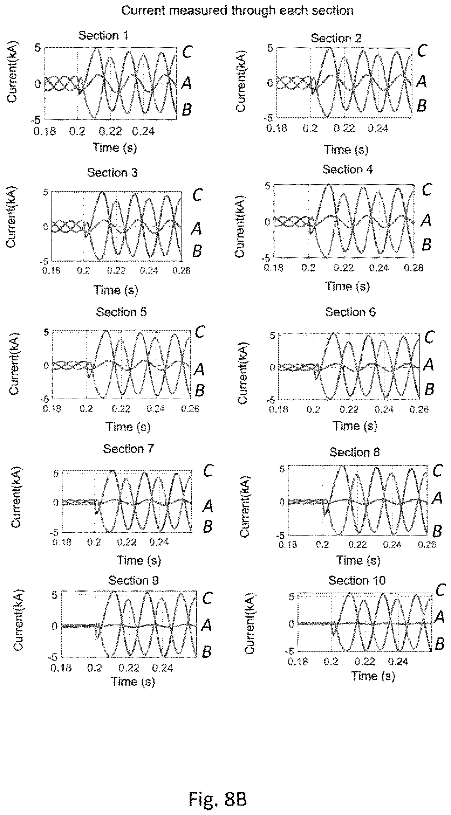

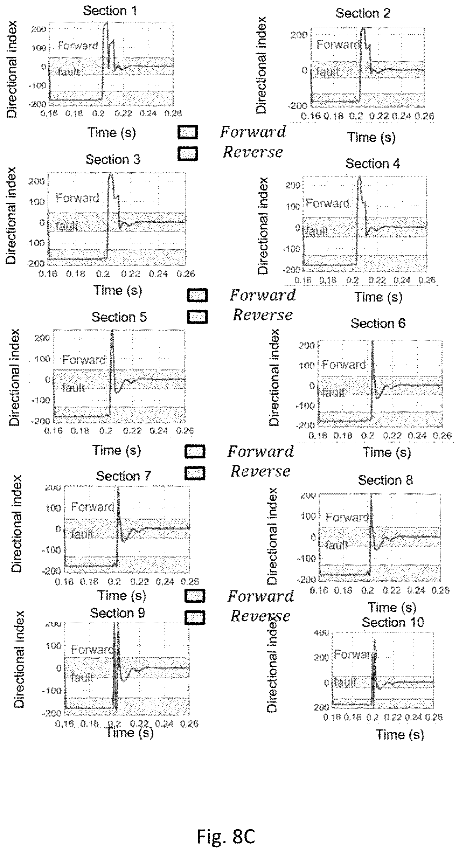

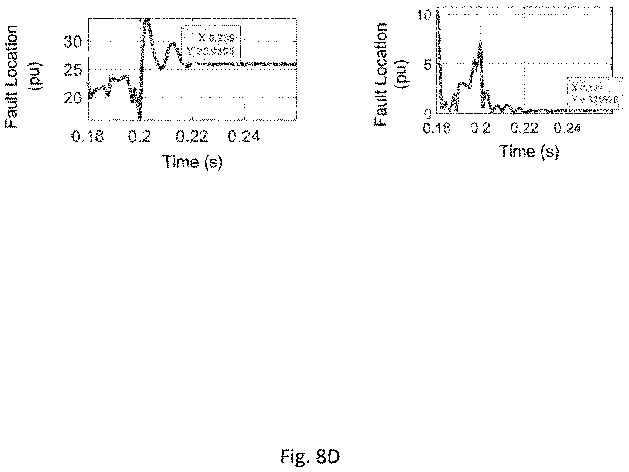

In the following, a further illustrative example for aiding understanding of the present invention is described.
Consider an BC-g fault at 28 km from the MV bus 8 in the feeder 10 as illustrated in Figs.1A and 1B. The fault resistance is 2Ω.
First, a three-phase voltage signal at the MV bus 8 and three-phase current signals of currents through each section $n=1$ to $10$ are obtained. The voltage signal at the MV bus 8 of the faulted feeder 10 is shown in Fig. 8A, and current signals for current through each section $n=1$ to 10 are shown in Fig. 8B, where the signal for each phase is respectively denoted with the letter "A", "B", or "C".
Subsequently, the fault direction for current signals for currents through sections 1 to 10 are determined. The determined fault directions for sections $n=1$ to 10 are shown in Fig. 8C. As can be seen, the fault direction of sections $n=1$ to 10 is "FORWARD", i.e., in the same direction. Notably, the fault direction for section $n=N=10$ is also "FORWARD". Consequently, based on the method steps as described for embodiments in the context of Figs. 2 and 4C, steps S134, S142 and S143 in particular, section $n=10$ is determined to be the faulted section.
Based on the obtained inputs and the determined faulted section, the method for fault location as described in the context of embodiments of Figs. 6A and 6B is performed. The resulting square roots of equation (22) are shown in Fig. 8D. As can be seen, square root d1 is larger than 1 and square root d2 is smaller than 1. Therefore, $d2$ is selected as the fault location d. The results are summarized in table 2 below.

| Table 2 | | | | | | |
|---|---|---|---|---|---|---|
| Root $d1$ | Root $d2$ | Root selected | $d_{abs}$ (km) = FS (km) + $d$ *fs (km) | Actual FL (km) | Error (m) | Error (%) |
| 25.94 | 0.3259 | 0.3259 | 27+(0.3259*3) = 27.957 | 28 | 43 | 0.143 |

The presented methods for determining a faulted section, fault location, and their combinations according to embodiments of the disclosure are reliable and accurate for collector grid network. They are simple to implement, do not require any complex measurements and computations, and can be implemented in existing IEDs platforms without requiring knowledge of the fault type or parameters of power sources such as IBRs.

While various embodiments of the present disclosure have been described above, it should be understood that they have been presented by way of example only, and not by way of limitation. Likewise, the various diagrams may depict an example architectural or configuration, which are provided to enable persons of ordinary skill in the art to understand exemplary features and functions of the present disclosure. Such persons would understand, however, that the present disclosure is not restricted to the illustrated example architectures or configurations, but can be implemented using a variety of alternative architectures and configurations. Additionally, as would be understood by persons of ordinary skill in the art, one or more features of one embodiment can be combined with one or more features of another embodiment described herein. Thus, the breadth and scope of the present disclosure should not be limited by any one of the above-described exemplary embodiments.

It is also understood that any reference to an element herein using a designation such as "first," "second," and so forth does not generally limit the quantity or order of those elements.

Rather, these designations can be used herein as a convenient means of distinguishing between two or more elements or instances of an element. Thus, a reference to first and second elements does not mean that only two elements can be employed, or that the first element must precede the second element in some manner.

Additionally, a person having ordinary skill in the art would understand that information and signals can be represented using any one of a variety of different technologies and techniques. For example, data, instructions, commands, information, signals, bits, and symbols, for example, which may be referenced in the above description can be represented by voltages, currents, electromagnetic waves, magnetic fields or particles, optical fields or particles, or any combination thereof.

A person of ordinary skill in the art would further appreciate that any one of the various illustrative logical blocks, units, processors, means, circuits, methods and functions described in connection with the aspects disclosed herein can be implemented by electronic hardware (e.g., a digital implementation, an analog implementation, or a combination of the two), firmware, various forms of program or design code incorporating instructions (which can be referred to herein, for convenience, as "software" or a "software unit"), or any combination of these techniques.

To clearly illustrate this interchangeability of hardware, firmware and software, various illustrative components, blocks, units, circuits, and steps have been described above generally in terms of their functionality. Whether such functionality is implemented as hardware, firmware or software, or a combination of these techniques, depends upon the particular application and design constraints imposed on the overall system. Skilled artisans can implement the described functionality in various ways for each particular application, but such implementation decisions do not cause a departure from the scope of the present disclosure. In accordance with various embodiments, a processor, device, component, circuit, structure, machine, unit, etc. can be configured to perform one or more of the functions described herein. The term "configured to" or "configured for" as used herein with respect to a specified operation or function refers to a processor, device, component, circuit, structure, machine, unit, etc. that is physically constructed, programmed and/or arranged to perform the specified operation or function.

Furthermore, a person of ordinary skill in the art would understand that various illustrative logical blocks, units, devices, components and circuits described herein can be implemented within or performed by an integrated circuit (IC) that can include a general purpose processor, a digital signal processor (DSP), an application specific integrated circuit (ASIC), a field programmable gate array (FPGA) or other programmable logic device, or any combination thereof. The logical blocks, units, and circuits can further include antennas and/or transceivers to communicate with various components within the network or within the device. A general purpose processor can be a microprocessor, but in the alternative, the processor can be any conventional processor, controller, or state machine. A processor can also be implemented as a combination of computing devices, e.g., a combination of a DSP and a microprocessor, a plurality of microprocessors, one or more microprocessors in conjunction with a DSP core, or any other suitable configuration to perform the functions described herein. If implemented in software, the functions can be stored as one or more instructions or code on a computer-readable medium. Thus, the steps of a method or algorithm disclosed herein can be implemented as software stored on a computer-readable medium.

Computer-readable media includes both computer storage media and communication media including any medium that can be enabled to transfer a computer program or code from one place to another. A storage media can be any available media that can be accessed by a computer. By way of example, and not limitation, such computer-readable media can include RAM, ROM, EEPROM, CD-ROM or other optical disk storage, magnetic disk storage or other magnetic storage devices, or any other medium that can be used to store desired program code in the form of instructions or data structures and that can be accessed by a computer.

In this document, the term "unit" as used herein, refers to software, firmware, hardware, and any combination of these elements for performing the associated functions described herein. Additionally, for purpose of discussion, the various units are described as discrete units; however, as would be apparent to one of ordinary skill in the art, two or more units may be combined to form a single unit that performs the associated functions according embodiments of the present disclosure.

Additionally, memory or other storage, as well as communication components, may be employed in embodiments of the present disclosure. It will be appreciated that, for clarity purposes, the above description has described embodiments of the present disclosure with reference to different functional units and processors. However, it will be apparent that any suitable distribution of functionality between different functional units, processing logic elements or domains may be used without detracting from the present disclosure. For example, functionality illustrated to be performed by separate processing logic elements, or controllers, may be performed by the same processing logic element, or controller. Hence, references to specific functional units are only references to a suitable means for providing the described functionality, rather than indicative of a strict logical or physical structure or organization.

Various modifications to the implementations described in this disclosure will be readily apparent to those skilled in the art, and the general principles defined herein can be applied to other implementations without departing from the scope of this disclosure. Thus, the disclosure is not intended to be limited to the implementations shown herein, but is to be accorded the widest scope consistent with the novel features and principles disclosed herein, as recited in the claims below.

**List of references**

[1] Afonso Cesar Tavares, A. Coelho and M.Magalhaes "Fast Wind Form Restoration Using Wireless Fault Sensors to Identify Faulted Segments*".*

[2] C. G. de Miguel, T. De Rybel and J. Driesen, "Implementation of a digital directional Fault Passage Indicator," IECON 2013 - 39th Annual Conference of the IEEE Industrial Electronics Society, Vienna, Austria, 2013, pp. 2075-2080.

[3] A. Mohamed, A. -E. Sayed, S. Moussa and A. Elsamahy, "Advanced Protection Technique for Wind Form Collector Feeder Divided into Multi Zones", 2019 IEEE Conference on Power Electronics and Renewable Energy (CPERE), Aswan, Egypt, 2019, pp. 560-566

[4] A. Mohamed, A. -E. Sayed, S. Moussa and A. Elsamahy, "Central Relaying Unit for Wind Form Based on Directional Angle and Differential Current", 2019 IEEE Conference on Power Electronics and Renewable Energy (CPERE), Aswan, Egypt, 2019, pp. 186-193

[5] Y. Gao, T. Bai, L. Yang, Y. He and H. Wang, "Fault Section Location of Collector Line in Wind Form Based on LightGBM Algorithm", 2023 IEEE International Conference on Advanced Power System Automation and Protection (APAP), Xuchang, China, 2023, pp. 280-284.

**Claims**

1.  Method for determining a fault location in a faulted section in a collector grid feeder, the method comprising:

    obtaining a first voltage and a first current signal at a local end of the section;
    obtaining a second current signal at a remote node of the section; and
    determining a fault location based on the first voltage signal, the first current signal, and the second current signal.

2.  The method according to the preceding claim,
    wherein the first voltage signal is obtained based on zero-sequence impedance parameters of the faulted section.

**3.** The method according to any of claims 1 or 2,
wherein the first current signal and the second current signal are obtained based on an obtained current through the faulted section.

**4.** The method according to claim 3,
wherein the current through the faulted section is measured at an infeed end of the faulted section.

**5.** The method according to any of claims 1 to 4,
wherein the first voltage signal is obtained based:

on a voltage signal at a collector bus at a local end of the collector grid feeder, and
a current through remaining sections of the collector grid feeder arranged in a remote direction from the faulted section.

**6.** The method according to any of claims 1 to 5,
wherein determining a fault location comprises obtaining a fault current based on the first voltage signal, the first current signal, and the second current signal.

**7.** Computer program product comprising instructions which, when executed by a processor of computer, cause the computer to carry out the method of any one of claims 1 to 6.

**8.** Non-transitory computer-readable medium comprising a computer program product according to claim 7.

**9.** Apparatus comprising:

a processor; and
a non-transitory computer-readable medium according to claim 8.

Fig. 1A

Fig. 1B

S110 | obtain MV bus voltage, first and second current signals

S120 | determine first and second fault direction

S130 | compare first and second fault direction

S140 | determine faulted section

Fig. 2

Fig. 3A

obtaining a current signal

202

Compute the positive and negative differentiation of current signal for each phase

204

Compute the voltage and current phasors from measured signals. Compute the phasor values of positive and negative differentiated current signals of phase a, b, c.

206

200

Using phase A as reference, Compute

$$\angle V_A = \angle V_A - \angle V_A, V_B = \angle V_B - \angle V_A, \angle V_C = \angle V_C - \angle V_A,$$

$$\angle I_A = \angle I_A - \angle V_A, I_B = \angle I_B - \angle V_A, \angle I_C = \angle I_C - \angle V_A$$

$$\angle +I'_A = \angle +I'_A - \angle V_A, \angle +I'_B = \angle +I'_B - \angle V_A, \angle +I'_C = \angle +I'_C - \angle V_A$$

$$\angle -I'_A = \angle -I'_A - \angle V_A, -I'_B = \angle -I'_B - \angle V_A, \angle -I'_C = \angle -I'_C - \angle V_A$$

208

Fig. 3B

Compute positive sequence components of voltage, current, positive, and negative differentiated current signals ⟵ 212

Is $|V_1| > 0.1 * V_{rated}$? ⟵ 214

No → Stop

Yes ↓

Wrap $\angle I_1$ to 360 degree and calculate difference of $\angle I_1$ during fault and pre-fault: $Th = \angle I_1(fault) - \angle I_1(pre-fault)$ ⟵ 216

Generate the reference signal and the fault direction (value) ⟵ 218

Is $60 < |Th| < 120$? ⟵ 220

No →

Yes ↓

Is $-45 < |D| < 45$? ⟵ 222

Yes →

No ↓

$D = D$          $D = D + 180$

⟵ 210

Is $-45 < D < 45$? ⟵ 224

Yes → Forward

No → Is $-225 < D < -135$? ⟵ 226

Yes → Reverse

No → Out of zone

Fig. 3C

Measure voltage and current signals. — 232

Compute the positive and negative differentiation of the current signal for phase a, b, c. — 234

Compute the voltage and current phasors from measured signals. Compute the phasor values of positive and negative differentiated current signals of phase a, b, c. — 236

Pre-processing of the signals (Example, phase A voltage is considered as reference and subtract the angle of phase A from all signals) — 238

Compute phasors of the current signal, positive differentiation of the current signal, and negative differentiation of the current signal. All these Phasor angle computations within the range of $-180^0$ to $+180^0$. — 240

— 230

Compute the reference signal by multiply the magnitude of positive current signal phasor with average of angles of positive and negative differentiated current signals. — 242

Compute the fault direction value (D) by subtracting the angle of reference signal with angle of positive sequence fault current. — 244

Direction of the fault is identified by checking the directional index with below directional zones. — 246

248

Is $-45^0 < D < 45^0$?

Yes → Forward

No →

250

Is $-225^0 < D < -135^0$

Yes → Reverse

No → Out of zone

Fig. 3D

Fig. 4A

# R₁

Forward

fault

Forward
Reverse

# R₂

Reverse

fault

Fig. 4B

S110 — Input voltage measured from MV bus and currents through different sections

Is fault detected?

yes

S120 — Compute directional index of section (n) and section (n+1)

S130

S131 — If dir(n)& dir(n+1) = FORWARD (OR) If dir(n) & dir(n+1) = REVERSE

No → S132 — If dir(n)= FORWARD & dir(n+1) = REVERSE (OR) If dir(n)= REVERSE & dir(n+1) = FORWARD

Yes

S133 — n=n+1

No

If n=N (total number of sections)

Yes

S134

S141 — Fault in section n

Yes

S140

S142 — If dir(N)=FORWARD

Yes

S143 — Fault in section N

Fig. 4C

Fig. 5A

Fig. 5B

Fig. 6A

EP 4 729 956 A1

S610 obtain faulted section

S620 obtain first voltage and current signals at local node and obtain second current signal at remote node

S630 determine fault location on faulted section

S621 obtain MV bus voltage and current through feeder in terminal direction

S622 obtain current through faulted section

S623 determine first voltage at local node

S624 determine current signals at local and remote node

S631 determine zero-sequence fault current

S632 determine fault location

Fig. 6B

Voltage and current waveforms

Fig.6. Voltage and current waveforms measured at MV bus for faulty feeder.

Fig. 7A

Current measured through each section

Fig. 7B

Fig. 7C

Fig. 7D

Fig. 8A

Current measured through each section

Fig. 8B

Fig. 8C

Fig. 8D

Europäisches Patentamt
European Patent Office
Office européen des brevets

# EUROPEAN SEARCH REPORT

**Application Number**

EP 24 20 6973

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | EP 2 528 184 B1 (SIEMENS AG [DE]) 10 September 2014 (2014-09-10) | 1-4,6-9 | INV. G01R31/08 |
| A | * paragraph [0071]; figure 1 * | 5 | |
| Y | WO 2019/229638 A1 (ABB SCHWEIZ AG [CH]) 5 December 2019 (2019-12-05) | 1-4,6-9 | |
| A | * paragraphs [0019], [0069] - [0081] * | 5 | |
| A | CN 103 323 744 B (SHANDONG ELECTRIC POWER ENGINEERING CONSULTING INST CO LTD) 22 April 2015 (2015-04-22) * the whole document * | 1-9 | |
| A | US 6 785 105 B2 (SCHWEITZER ENGINEERING LAB INC [US]) 31 August 2004 (2004-08-31) * claim 1; figure 1 * | 1-9 | |

**TECHNICAL FIELDS SEARCHED (IPC)**

G01R

The present search report has been drawn up for all claims

| Place of search | Date of completion of the search | Examiner |
|---|---|---|
| Munich | 20 March 2025 | O'Callaghan, D |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P4C01)

## ANNEX TO THE EUROPEAN SEARCH REPORT
## ON EUROPEAN PATENT APPLICATION NO.

EP 24 20 6973

This annex lists the patent family members relating to the patent documents cited in the above-mentioned European search report.
The members are as contained in the European Patent Office EDP file on
The European Patent Office is in no way liable for these particulars which are merely given for the purpose of information.

20-03-2025

| Patent document cited in search report | | Publication date | Patent family member(s) | | Publication date |
|---|---|---|---|---|---|
| EP 2528184 | B1 | 10-09-2014 | CN | 102801176 A | 28-11-2012 |
| | | | DK | 2528184 T3 | 20-10-2014 |
| | | | EP | 2528184 A1 | 28-11-2012 |
| | | | US | 2012300510 A1 | 29-11-2012 |
| WO 2019229638 | A1 | 05-12-2019 | NONE | | |
| CN 103323744 | B | 22-04-2015 | NONE | | |
| US 6785105 | B2 | 31-08-2004 | AU | 2003268053 A1 | 23-02-2004 |
| | | | US | 2004021995 A1 | 05-02-2004 |
| | | | WO | 2004013643 A2 | 12-02-2004 |

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 23210743 A

**Non-patent literature cited in the description**

- **AFONSO CESAR TAVARES** ; **A. COELHO** ; **M.MA-GALHAES**. *Fast Wind Form Restoration Using Wireless Fault Sensors to Identify Faulted Segments*
- **C. G. DE MIGUEL** ; **T. DE RYBEL** ; **J. DRIESEN**. Implementation of a digital directional Fault Passage Indicator. *IECON 2013 - 39th Annual Conference of the IEEE Industrial Electronics Society, Vienna, Austria*, 2013, 2075-2080
- **A. MOHAMED** ; **A. -E. SAYED** ; **S. MOUSSA** ; **A. ELSAMAHY**. Advanced Protection Technique for Wind Form Collector Feeder Divided into Multi Zones. *2019 IEEE Conference on Power Electronics and Renewable Energy (CPERE), Aswan, Egypt*, 2019, 560-566
- **A. MOHAMED** ; **A. -E. SAYED** ; **S. MOUSSA** ; **A. ELSAMAHY**. Central Relaying Unit for Wind Form Based on Directional Angle and Differential Current. *2019 IEEE Conference on Power Electronics and Renewable Energy (CPERE), Aswan, Egypt*, 2019, 186-193
- **Y. GAO** ; **T. BAI** ; **L. YANG** ; **Y. HE** ; **H. WANG**. Fault Section Location of Collector Line in Wind Form Based on LightGBM Algorithm. *2023 IEEE International Conference on Advanced Power System Automation and Protection (APAP), Xuchang, China*, 2023, 280-284